# FASCICULE DE BREVET EUROPEEN

(11) **EP 2 828 801 B1**
(45) Date de publication et mention de la délivrance du brevet: **19.10.2016**
(21) Numéro de dépôt: 13711052.4
(22) Date de dépôt: 21.03.2013
(51) Int. Cl.: G06K 19/077, H05K 3/30

(54) **CARTE A PUCE ET PROCEDE DE FABRICATION**
CHIPKARTE UND ENTSPRECHENDES HERSTELLUNGSVERFAHREN
CHIP CARD AND MANUFACTURING METHOD

(30) Priorité: 22.03.2012 EP 12305334
(43) Date de publication de la demande: 28.01.2015
(73) Titulaire: Gemalto SA, 92190 Meudon (FR)
(72) Inventeur: GUIJARRO, Sébastien, F-92190 Meudon (FR); LAVIRON, Thierry, F-92190 Meudon (FR); DOSSETTO, Lucile, F-92190 Meudon (FR)
(74) Mandataire: Cassagne, Philippe M.J.
(86) Numéro de dépôt international: PCT/EP2013/055934
(87) Numéro de publication internationale: WO 2013/139910

(56) Documents cités:
- EP-A1- 1 698 455
- EP-A2- 0 211 360
- DE-A1- 4 328 469
- FR-A1- 2 862 410

## Description

La présente invention se rapporte au domaine technique des modules électroniques, aux procédés de fabrication d'un module électronique, ainsi qu'aux dispositifs électroniques, en particulier aux cartes à puce, comportant au moins un module électronique. Plus précisément, l'invention se rapporte aux modules électroniques sécurisés.

De façon générale, les modules électroniques sont formés par un film support diélectrique sur lequel est laminée une couche métallisée. Sur la face opposée à la couche métallisée est collée une puce électronique connectée à différentes zones de la couche métallisée.

Dans un dispositif électronique, le module électronique est collé dans une cavité prévue à cet effet dans le corps du dispositif.

Ce genre de module électronique trouve application notamment dans les cartes à puces.

Généralement, afin de protéger la puce électronique ainsi que ses connectiques la reliant aux différentes zones de la couche métallique, une encapsulation est réalisée par moulage d'une résine protectrice sur le module électronique. Cette encapsulation est habituellement réalisée en résine époxy ou composants de moulage époxy (Epoxy Mold Compound ou EMC) qui sont de couleur foncée. Les corps de carte dans lesquels sont implantés les modules électroniques sont quant à eux généralement réalisés en matière plastique de teinte claire, ce qui conduit par contraste à une visibilité du module électronique au travers du corps de carte.

Dans le domaine des cartes à puce haut de gamme, le fait que le module électronique soit visible au travers de la carte n'est pas accepté pour la commercialisation. Il existe cependant des EMC de couleur claire qui seraient invisible au travers de la carte, cependant ces derniers sont très couteux et difficiles à mettre en oeuvre. En effet, ces EMC ont tendance à adhérer au moule et il est nécessaire d'arrêter
fréquemment la chaine de production pour nettoyer le moule, augmentant de fait les coûts.

Le problème de visibilité du module électronique au travers du corps de carte pourrait également être évité par l'apposition d'une couche de personnalisation sur le dos de la carte à puce, rendant de fait invisible le module électronique. Cependant, pour certains types de cartes sécurisées, le dos de la carte est recouvert d'une couche de sécurité transparente sur laquelle n'est appliquée aucune couche opaque afin justement de garantir la sécurité de la carte.

DE 4328469 décrit une carte à puce selon le préambule de la revendication 1, et dans laquelle la couche colorée est portée par le fond de la cavité du corps de carte. L'inconvénient de la solution décrite dans ce document à un impact significatif sur le temps et les coûts de production de la carte

Un des buts de la présente invention est donc de remédier au moins partiellement aux inconvénients de l'art antérieur et de proposer une carte à puce ainsi que son procédé de fabrication permettant une invisibilité du module électronique au travers de la carte.

Ainsi, la présente invention concerne une carte à puce selon la revendication 1.

Selon un aspect de l'invention, la couleur de la au moins une couche colorée est identique à la couleur du corps de carte.

Selon l'invention, le module électronique comporte une résine de protection et au moins une couche colorée est portée par ladite résine de protection.

Selon un autre aspect de l'invention, la au moins une couche colorée est réalisée par impression d'une encre.

La présente invention concerne également un procédé de fabrication d'une carte à puce comportant un corps de carte et un module électronique placé dans une cavité du corps de carte, caractérisé en ce que ledit procédé de fabrication comporte au moins une étape d'application d'au moins une couche colorée entre le module électronique et le fond de la cavité du corps de carte.

Selon un aspect du procédé selon l'invention, au moins une étape d'application de la au moins une couche colorée est réalisée sur le fond de la cavité du corps de carte.

Selon un autre aspect du procédé selon l'invention, le module électronique comporte une résine de protection et la au moins une étape d'application de la au moins une couche colorée est réalisée sur ladite résine de protection.

Selon un autre aspect du procédé selon l'invention, l'étape d'application de la au moins une couche colorée est réalisée lors du procédé d'encapsulation, entre une étape d'encapsulation du module électronique et une étape de contrôle dudit module électronique.

Selon un autre aspect du procédé selon l'invention, l'étape d'application de la au moins une couche colorée est une étape d'impression d'une encre.

Selon, un autre aspect du procédé selon l'invention, l'étape d'impression est réalisée par tampographie.

D'autres caractéristiques et avantages de l'invention apparaîtront plus clairement à la lecture de la description suivante, donnée à titre d'exemple illustratif et non limitatif, et des dessins annexés parmi lesquels :
- la figure 1 montre une représentation schématique en coupe d'un module électronique inséré dans un corps de carte,
- la figure 2 montre un organigramme des différentes étapes d'un procédé de fabrication d'un module électronique et d'une carte à puce.

Les éléments identiques sur toutes les figures sont indiqués par les mêmes numéros de références.

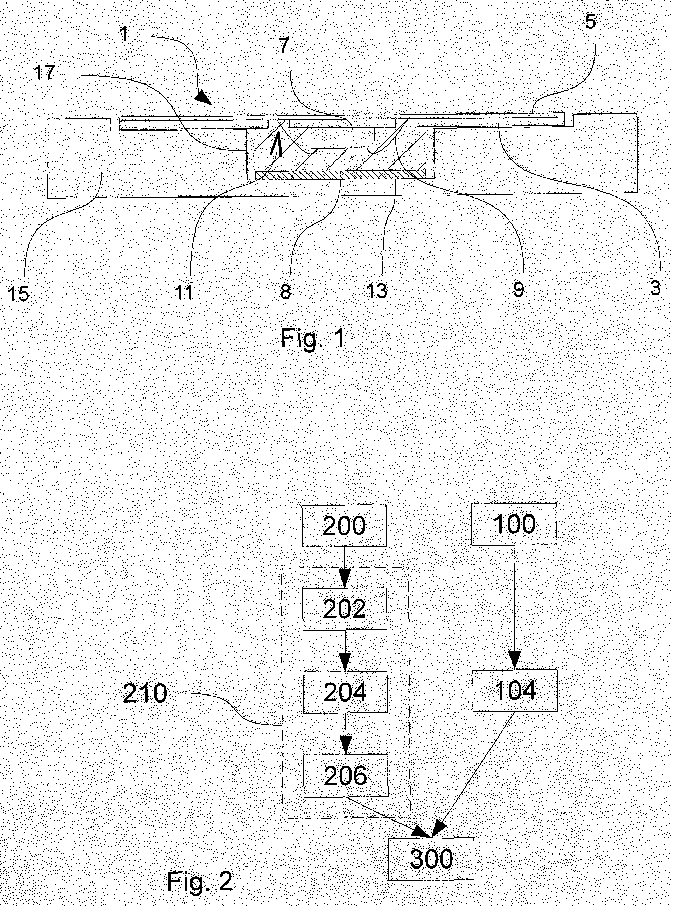

La figure 1 montre une représentation schématique en coupe d'un module électronique 1 inséré dans un corps de carte 15. Le module électronique 1 comporte un film support diélectrique 3 ayant au moins une zone de contact électrique 5 sur une face, et ayant sur la face opposée une puce électronique 7 reliée à ladite au moins une zone de contact électrique 5 par des connectiques 9 passant par des orifices 11 au travers du film support 3, ladite puce électronique 7 et les connectiques 9 étant recouvertes par une résine de protection 8 par exemple de type époxy.

Le corps de carte 15 comporte quand à lui une cavité 17 dans laquelle est placé le module électronique 1 de telle sorte que la face portant la zone de contact électrique 5 est orientée vers l'extérieur de la cavité 17. Le module électronique 1 est généralement maintenu à l'intérieur de la cavité 17 au moyen d'adhésif (non représenté).

Entre la résine de protection 8 et le fond de la cavité 17 du corps de carte 15 est placé au moins une couche colorée 13. Cette couche colorée 13, de même couleur que le corps de carte 15, est suffisamment opaque pour diminuer la visibilité du module électronique 1 au travers du corps de carte 15. En effet, les résines de protection 8 utilisées pour recouvrir la puce électronique 7 et ses connectiques 9 sont généralement de couleur sombre, alors que le corps de carte 15 est de couleur claire. L'addition d'au moins une couche colorée 13 entre ces éléments permet ainsi de camoufler la couleur de la résine de protection 8 et donc de dissimuler la présence du module électronique 1 au travers du corps de carte 15.

Une couche colorée 13 peut être portée par le module électronique 1, plus précisément par la résine protectrice 8 de ce dernier, par le fond de la cavité 17 du corps de carte 15 ou encore par les deux en même temps si plusieurs couches colorées 13 sont présentes entre le module électronique 1 et le fond de la cavité 17. Dans l'exemple présenté par la figure 1, une seule couche colorée 13 est présente entre la résine de protection 8 et le fond de la cavité 17 du corps de carte 15.

Cette couche colorée 13 est préférentiellement réalisée par impression d'une encre opaque, classiquement utilisée dans le domaine des cartes à puces et de couleur identique au corps de carte et formant une couche d'épaisseur de l'ordre de 10 à 15 µm. Dans le cas ou une couche colorée 13 est portée par la résine protectrice 8, l'encre utilisée est une encre connue de l'homme du métier et qui peut adhérer à la résine de protection 8. Dans le cas ou une couche colorée 13 est portée par le fond de la cavité 17, l'encre utilisée sera alors une encre connue de l'homme du métier qui peut adhérer à la matière dans laquelle est réalisée le corps de carte.

La figure 2 montre un organigramme d'un procédé de fabrication d'une carte à puce comportant un module électronique 1 placé dans une cavité 17 d'un corps de carte 15 et comportant au moins une couche colorée 13 placée entre la résine de protection 8 du module électronique et le fond de la cavité 17 du corps de carte 15.

Les premières étapes 100 et 200, connues de l'homme du métier, sont respectivement des étapes de fourniture des éléments constituant la carte à puce finale.

Il s'agit d'une étape 200 de fourniture d'un module électronique 1 comportant un film support diélectrique 3 ayant au moins une zone de contact électrique 5 sur une face, et ayant sur la face opposée une puce électronique 7 reliée à ladite au moins une zone de contact électrique 5 par des connectiques 9 passant par des orifices 11 au travers du film support 3 et d'une étape 100 de fourniture d'un corps de carte 15 comportant une cavité 17. Généralement, ces fournitures d'éléments se font sous forme de bobines et font partie du procédé de fabrication standard connu de l'homme du métier.

Suite à l'étape de fourniture 200 du module électronique 1, un procédé d'encapsulation 210 classique et connu de l'homme du métier est réalisé sur le module électronique 1.

Ce procédé d'encapsulation 210 peut comporter notamment une étape d'encapsulation 202 réalisée sur le module électronique 1. Cette étape consiste en une application de résine de protection 8 sur le module électronique 1, par exemple au moyen d'un moule venant recouvrir la puce électronique 7 et ses connectiques 9 et dans lequel est injecté une résine époxy.

Suite à l'étape d'encapsulation 202, une étape de contrôle 206 du module électronique 1 est réalisée. Cette étape est une étape classique dans un procédé d'encapsulation et sert essentiellement à vérifier visuellement la qualité de l'encapsulation.

Intercalée entre l'étape d'encapsulation 202 et l'étape de contrôle 206, une étape supplémentaire d'application 204 d'une couche colorée 13 sur la résine dé protection 8 est réalisée. Cette étape d'application 204 consiste notamment en une application sur la résine de protection 8 d'une couche colorée 13 d'une couleur identique à la couleur du corps de carte 15.

Cette étape d'application 204 est réalisée juste après l'étape d'encapsulation 202. Plus précisément, dans la chaine de production et à la suite de l'unité de production réalisant l'encapsulation lors de l'étape 202, une unité d'application est installée et réalise l'application de la couche colorée 13. Le fait que l'application de la couche colorée 13 se fasse à ce moment permet de réduire l'impact de l'étape application 204 sur le temps et les coûts du procédé de fabrication d'une carte à puce connu de l'homme du métier.

L'unité d'application peut, par exemple et préférentiellement, être une unité d'impression par tampographie (ou *stamping* en anglais), c'est-à-dire une unité où un tampon encreur vient récupérer de l'encre, sur une source et la déposer sur la résine de protection 8, formant une couche d'une épaisseur de l'ordre de 10 à 15µm. Un même tampon encreur peut effectuer cette impression sur plusieurs modules électroniques 1 simultanément. Néanmoins, l'unité d'application peut tout à fait être une unité d'impression par sérigraphie, jet d'encre, une unité d'application d'une couche colorée 13 autocollante, ou tout autre moyen connu de l'homme du métier.

Parallèlement et optionnellement, suite à l'étape 100 de fourniture du corps de carte 15, une autre étape d'application 104 d'une couche colorée 13 peut être réalisée au fond de la cavité 17 du corps de carte 15. Cette autre étape d'application 104 peut également être réalisée par une unité d'impression par tampographie, sérigraphie, jet d'encre, une unité d'application d'une couche colorée 13 autocollante, ou tout autre moyen connu de l'homme du métier.

La dernière étape 300 du procédé de fabrication d'une carte à puce consiste en une étape classique d'encartage, c'est-à-dire de mise en place et de fixation du module électronique 1 dans la cavité 17 du corps de carte 15.

Ainsi, on voit bien que la carte à puce selon l'invention permet de diminuer la visibilité du module électronique 1, notamment de sa résine de protection 8, au travers du corps de carte 15 du fait de la présence d'au moins une couche colorée 13 placée entre le fond de la cavité 17 du corps de carte 15 et le module électronique 1. De plus la mise en place de cette couche colorée 13 a un impact limité sur le temps et les coûts de production du fait qu'elle est effectuée lors du processus d'encapsulation 210.

## Revendications

1. Carte à puce comportant un corps de carte (15) et un module électronique (1) placé dans une cavité (17) du corps de carte (15), ledit module électronique (1) comportant une résine de protection (8) et une couche colorée (13) étant placée entre le module électronique (1) et le fond de la cavité (17) du corps de carte (15), **caractérisé en ce que** cette couche colorée est portée par la résine de protection.

2. Carte à puce selon la revendication 1, **caractérisé en ce que** la couleur de la au moins une couche colorée (13) est identique à la couleur du corps de carte (15).

3. Carte à puce selon la revendication 1, **caractérisé en ce que** la au moins une couche colorée (13) est réalisée par impression d'une encre.

4. Procédé de fabrication d'une carte à puce comportant un corps de carte (15) et un module électronique (1) placé dans une cavité (17) du corps de carte (15), le module comprenant une résine de protection (8), ledit procédé de fabrication comporte au moins une étape d'application (204) d'au moins une couche colorée (13) entre le module électronique (1) et le fond de la cavité (17) du corps de carte (15), **caractérisé par** l'application de la couche colorée sur la résine de protection.

5. Procédé de fabrication selon la revendication précédente, **caractérisé en ce que** l'étape d'application (204) de la au moins une couche colorée (13) est réalisée lors du procédé d'encapsulation (210), entre une étape d'encapsulation (202) du module électronique (1) et une étape de contrôle (206) dudit module électronique (1).

6. Procédé de fabrication selon la revendication 6, **caractérisé en ce que** l'étape d'application (204) de la au moins une couche colorée (13) est une étape d'impression d'une encre.

7. Procédé de fabrication selon la revendication précédente, **caractérisé en ce que** l'étape d'impression est réalisée par tampographie.

## Patentansprüche

1. Chipkarte mit einem Kartenkörper (15) und einem elektronischen Modul (1), das in eine Aussparung (17) in den Kartenkörper (15) eingelassen ist, wobei das elektronische Modul (1) eine Harzschicht (8) und eine farbige Schicht (13) umfasst, die zwischen dem elektronischen Modul (1) und dem Boden der Aussparung (17) im Kartenkörper (15) eingefügt sind, die farbige Schicht wird von der Harzschicht getragen.

2. Chipkarte nach Anspruch 1, **dadurch gekennzeichnet, dass** die mindestens eine farbige Schicht (13) von derselben Farbe ist wie der Kartenkörper (15).

3. Chipkarte nach Anspruch 1, **dadurch gekennzeichnet, dass** die mindestens eine farbige Schicht (13) durch Aufdruck einer Farbe hergestellt wird.

4. Herstellungsverfahren für eine Chipkarte mit einem Kartenkörper (15) und einem elektronischen Modul (1), das in eine Aussparung (17) in den Kartenkörper (15) eingelassen ist, wobei das Modul eine Harzschicht (8) umfasst. Das Herstellungsverfahren umfasst mindestens einen Verfahrensschritt zur Applikation (204) mindestens einer farbigen Schicht (13) zwischen dem elektronischen Modul (1) und dem Boden der Aussparung (17) im Kartenkörper (15), die farbige Schicht wird dabei auf die Harzschicht aufgebracht.

5. Herstellungsverfahren nach dem vorhergehenden Anspruch, **dadurch gekennzeichnet, dass** der Verfahrensschritt zur Applikation (204) der mindestens einen farbigen Schicht (13) beim Einkapselungsprozess (210) durchgeführt wird, zwischen einem Verfahrensschritt zur Einkapselung (202) des elektronischen Moduls (1) und einem Arbeitsschritt zur Kontrolle (206) des elektronischen Moduls (1).

6. Herstellungsverfahren nach Anspruch 6, **dadurch gekennzeichnet, dass** der Verfahrensschritt zur Applikation (204) der mindestens einen farbigen Schicht (13) aus dem Aufdruck einer Farbe besteht.

7. Herstellungsverfahren nach dem vorhergehenden Anspruch, **dadurch gekennzeichnet, dass** das Bedrucken durch Tampondruck erfolgt.

## Claims

1. A smart card comprising a card body (15) and an electronic module (1) placed in a recess (17) of the card body (15), where said electronic module (1) comprises protective resin (8) and a coloured coat (13) and is placed between the electronic module (1) and the bottom of the recess (17) in the card body (15), **characterised in that** the coloured coat is carried by the protective resin.

2. A smart card according to claim 1, **characterised in that** the colour of the at least one coloured coat (13) is identical to the colour of the card body (15).

3. A smart card according to claim 1, **characterised in that** the at least one coloured coat (13) is applied by means of ink printing.

4. A method for manufacturing a smart card comprising a card body (15) and an electronic module (1) placed in a recess (17) of the card body (15), where the module comprises protective resin (8); said manufacturing method comprises at least one step (204) for applying at least one coloured coat (13) between the electronic module (1) and the bottom of the recess (17) of the card body (15), **characterised by** the application of the coloured coat on the protective resin.

5. A manufacturing method according to the previous claim, **characterised in that** the step (204) for applying the at least one coloured coat (13) is carried out during the encapsulation process (210), between a step (202) of encapsulating the electronic module (1) and a step (206) of inspecting said electronic module (1).

6. A manufacturing method according to claim 6, **characterised in that** the step (204) of applying the at least one coloured coat (13) is carried out by means of ink printing.

7. A manufacturing method according to the previous claim, **characterised in that** the printing step is carried out by stamping.
